(19) Europäisches Patentamt / European Patent Office / Office européen des brevets

(11) **EP 3 447 915 B1**

(12) **EUROPEAN PATENT SPECIFICATION**

(45) Date of publication and mention
of the grant of the patent:
**23.09.2020  Bulletin 2020/39**

(21) Application number: **18201014.0**

(22) Date of filing: **18.11.2016**

(51) Int Cl.:
*H03H 7/20* *(2006.01)*          *H03H 11/20* *(2006.01)*
*H03H 7/18* *(2006.01)*          *H03H 7/25* *(2006.01)*
*H03H 11/22* *(2006.01)*         *H03H 11/24* *(2006.01)*
*H04L 27/20* *(2006.01)*         *H01P 1/22* *(2006.01)*
*H01Q 3/28* *(2006.01)*          *H01Q 3/36* *(2006.01)*

(54) **APPARATUS AND METHOD FOR VARYING AMPLITUDE AND PHASE OF SIGNALS ALONG SIGNAL PATH**

VORRICHTUNG UND VERFAHREN ZUR VERÄNDERUNG DER AMPLITUDE UND PHASE VON SIGNALEN ENTLANG EINES SIGNALWEGS

APPAREIL ET PROCÉDÉ PERMETTANT DE FAIRE VARIER L'AMPLITUDE ET LA PHASE DE SIGNAUX LE LONG D'UN TRAJET DE SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**27.02.2019  Bulletin 2019/09**

(62) Document number(s) of the earlier application(s) in accordance with Art. 76 EPC:
**16002459.2 / 3 324 540**

(73) Proprietor: **HENSOLDT Sensors GmbH**
**82024 Taufkirchen (DE)**

(72) Inventors:
• **CHARTIER, Sébastien**
  **89077 Ulm (DE)**
• **PAGLIA, Angelo**
  **89077 Ulm (DE)**

(74) Representative: **LifeTech IP**
**Spies & Behrndt Patentanwälte PartG mbB**
**Elsenheimerstraße 47a**
**80687 München (DE)**

(56) References cited:
**KR-A- 20110 015 961     US-A1- 2013 135 022**

## Description

Field of the Invention

The present invention relates to an apparatus and a method for varying amplitude and phase of signals and, in particular, to a distributed attenuator based vector modulator and a beamformer architecture using the distributed attenuator based vector modulator.

Background

In many applications such as ultra-wideband or phased-array antenna capable of covering several microwave bands (e.g. C-, X- and Ku-Band), there is a demand to vary the amplitude and phase of the received or sent signals over a very wide bandwidth. In particular, a current trend of modern phased-array antenna is to increase further the achievable RF bandwidth that can be covered by an antenna. This may lead in the future to several applications (e.g. communication applications and RADAR) in a single antenna system. The challenge for the transmit and/or receive modules is, however, to achieve phase and amplitude control over a wide frequency range.

An active phased-array antenna may, inter alia, use transmit and/or receive modules to steer the beam in a defined direction. To achieve the beam steering, phase and amplitude of signals are controlled within each module.

One possible way of achieving broadband phase and amplitude variations is to use a so-called vector modulator. A possible implementation of the vector modulator is as follows: The signal is split into four 90° phase shifted signals with equal amplitudes. Each of the four signals, also called vectors, is fed into an amplifier with amplitude variation capabilities (usually referred as variable gain amplifier or VGA). The four resulting vectors are finally combined within a signal adder (e.g. a passive power combiner). Based on this topology, a defined phase and amplitude variation can be achieved over a wide frequency range. Such systems are, for example, disclosed in: Kwang-Jin Koh, and Gabriel M. Rebeiz, "An X- and Ku-Band 8-Element Phased-Array Receiver in 0.18-$\mu$m SiGe BiCMOS Technology" IEEE Journal of Solid-Sate Circuits, Vol. 43, No. 6, June 2008; and in Uwe Mayer, Michael Wickert, Ralf Eickhoff, and Frank Ellinger, "2-6-GHz BiCMOS Polar- Based Vector Modulator for S- and C-Band Diversity Receivers" IEEE Transactions on Microwave Theory and Techniques, Vol. 60, Issue: 3, June 2008. A differential vector modulator is disclosed in KR10-2011-0015961.

However, the known VGAs have several disadvantages. The transmission phase variation of the amplifier over the dynamic range is usually large. Phase compensation techniques can be applied to reduce this effect, however, they tend to be effective only over a narrow frequency range. This parasitic transmission phase variation can lead to inaccurate phase and amplitude control. Additionally, amplifiers require a trade-off between linearity and power consumption. A higher robustness against interferers and jamming requires a higher power consumption which is critical since transmit and/or receive modules have a limited prime power and cooling capability. An additional issue of VGAs used in a vector modulator is the variation over process-voltage-temperature (PVT). These variations can lead to an increased unreliability of the phase and amplitude control. Since a VGA usually requires an analog control (voltage or current) and since transmit and/or receive modules are usually controlled using a digital signal, a digital-analog converter (DAC) is necessary. The required DACs increase the overall power consumption and add further inaccuracy since they are also sensitive to PVT.

Another possible way to vary amplitudes are distributed step attenuators. Such attenuators are disclosed in: Byung-Wook Min and Gabriel M. Rebeiz, "A 10-50-GHz CMOS Distributed Step Attenuator With Low Loss and Low Phase Imbalance" IEEE Journal of Solid-Sate Circuits, Vol. 42, No. 11, November 2007; and in Kyungwon Kim, Hyo-Sung Lee and Byung-Wook Min, "V-W Band CMOS Distributed Step Attenuator With low Phase Imbalance" IEEE Microwave And Wireless Components Letters, Vol. 24, No. 8, August 2014.

However, because of its single-ended topology, the distributed step attenuator is very sensitive to parasitic effects created by the assembly. This is especially critical on silicon based semiconductor technology because the bondwire connecting the ground of the chip to the ground of the circuit carrier (e.g. printed circuit board or quad flat no-lead packaging) might strongly reduce the overall performance. This leads to an assembly/packaging problem.

Hence, there is a need for a circuitry that is capable of achieving an accurate phase and amplitude control over a wide bandwidth, a robust phase and amplitude accuracy over PVT and a high linearity. There is a further need to solve the mentioned assembly/packaging issues. There is yet another need for components that bring together the functionality required to achieve phase and amplitude variations within the transmit and/or receive module for providing a desired beam steering. Such systems will be referred hereafter as beamformer.

Summary

At least some of the above mentioned problems are solved by an attenuator according to claim 1, a beamformer according to claim 10 and a method according to claim 12. The dependent claims relate to further advantageous realizations of the subject matter of the independent claims.

The present invention relates to an attenuator suitable to be used within one of the defined apparatuses. The attenuator comprises a two-line input and a two-line output connected by a first signal path and a second signal path for enabling the attenuator to attenuate differential signals, a first plurality of transmission lines arranged along the first signal path and a second plurality of transmission lines arranged along the second signal line. One or more varistors are arranged between adjacent transmission lines along the first signal path and the second signal path to controllably connect the first signal path with the second signal path, thereby attenuating the differential signals.

The present invention relates also to an apparatus for varying amplitude and phase of a signal along at least one signal path. The apparatus comprises an input for receiving an input signal, an output for providing an output signal, a splitter, a plurality of the attenuators, and an adder. The splitter is configured to split the input signal into a plurality of phase shifted signals. The attenuators are controllable by corresponding control signals and are configured to attenuate each of the plurality of phase shifted signals. The adder (or combiner) is configured to add the attenuated signals and to provide the added signals as the output signal.

It is understood that the apparatus is able to vary the amplitude and/or the phase of an input signal. It is not necessary that both the amplitude and the phase are varied. In addition, the variation in the phase can be achieved by different amplitude variations for different phase components of the signal. Therefore, even if the phase of a signal has been shifted when the signal passes the apparatus, this does not imply that apparatus directly shifts the phase. The apparatus may achieve this result by merely attenuating the signal components.

Furthermore, the plurality of phase shifted signals shall cover all possible number of phase shifted signals (e.g. 2, 3, 4, 6, 8, etc.). However, as it will be set out in detail below, it is of advantage to consider, for example, two or four phase shifted signals. The signals along the signal path may be signals received and/or sent by antenna modules. The attenuators may individually attenuate the corresponding signal component propagating through the respective attenuator. The adder is, for example, a vector adder that combines the signals such that the phase and amplitude of the signals are added (as vectors).

Optionally, each attenuator comprises multiple transmission lines along the signal path and a plurality of varistors, which are individually controllable by the corresponding control signals. Each varistor of the plurality of varistors may be arranged between adjacent transmission lines and is configured to lower an amplitude of a signal propagating along the signal path depending on one of the control signals.

The transmission lines may be configured to provide an impedance matching along the signal path. Impedance jumps may otherwise result in reflection of signals or other adverse losses along the signal path.

Optionally, at least some of the attenuators may comprise each at least m varistors and a decoder, wherein the corresponding control signal may be fed into the decoder and indicates n input states (n, m being integer numbers). The decoder may be configured to transform the n input states into m output control signals and to provide the output control signals to the m varistors respectively, wherein m is larger than n. It is understood that n signals do not necessarily imply n separate signal lines, they may also be transmitted over one line as non-interfering signals.

Optionally, the splitter may be configured to generate as phase shifted signals from the input signal four quadrature vector signals and to provide each of the quadrature vector signals to one respective attenuator of the plurality of attenuators.

Optionally, the plurality of attenuators may comprise an output attenuator arranged between the adder and the output to attenuate the added signal and provide the attenuated, added signal as output signal.

Optionally, at least some of the attenuators comprise each a single-ended input and a single-ended output connected by a corresponding portion of the signal path, and the varistors are configured to provide controllable parallel paths between the portion of the signal path and ground.

Optionally, each varistor comprises a transistor connected between the portion of the signal path and the ground, the transistor comprises a gate terminal controlled by one of the control signals. Each of the varistor may further comprise a capacitor connecting the signal path to the ground and providing a phase compensation or adaptation of the signal propagating along the portion of the signal path. These optional capacitors enable a reduction of the physical dimension of transmission lines.

Optionally, the splitter is further configured to provide, based on the phase-shifted signals, pairs of differential signals. At least some of the attenuators may comprise each a two-line input and a two-line output (i.e. the apparatus may not be single-ended) connected by a first signal path and a second signal path for enabling the attenuator to attenuate differential signals. In addition, a first plurality of transmission lines may be arranged along the first signal path and a second plurality of transmission lines may be arranged along the second signal line. One or more controllable varistors may be arranged between adjacent transmission lines along the first signal path and the second signal path to connect the first signal path with the second signal path, thereby attenuating the differential signals.

Optionally, the first plurality of transmission lines is arranged to decouple from the second plurality of transmission lines. In further embodiments the first plurality of transmission lines and the second plurality of transmission lines may couple to each other to form pairs so that signals propagating along the first signal path interact with signals propagating along the second signal path. Respective varistors may be arranged between neighboring pairs of transmission lines to attenuate amplitudes of the signals propagating along the first signal path and signals propagating along the second signal path.

Optionally, each varistor comprises at least one transistor controlled by the corresponding control signals to simultaneously attenuate amplitudes of signals propagating along the first signal path and signals propagating along the second signal path. Again, capacitors may connect the first and/or second signal path to the ground or with each other to provide a phase adaptation of the signal propagating along the first and/or second signal paths. Consequently, the physical dimension of transmission lines may be reduced.

The present invention relates also to a beamforming architecture with an antenna array and one or more transmit and/or receive modules and at least two of the apparatuses defined before (in this context these apparatuses are also called beamformers). Optionally, the beamforming architecture comprises a control unit configured to control the plurality of attenuators in the at least two apparatuses to direct (or steer) a transmission beam in a defined transmission direction or to increase a sensitivity for beams received from a defined receiving direction.

The present invention relates further to a method for varying amplitude and phase of signals along a signal path. The method comprises the steps of: receiving an input signal, splitting the input signal into a plurality of phase shifted signals, attenuating the phase shifted signals based on corresponding control signals, and adding the attenuated signals and to provide the added signals as an output signal.

At least some of the problems of conventional systems mentioned at the beginning are solved by embodiments by using distributed step attenuators to vary amplitudes of the vectors within a vector modulator. Such a vector modulator may, for example, be part of a beamformer architecture. Embodiments of the distributed step attenuators have several essential advantages such as very low parasitic phase variation over amplitude sweep, high linearity, low-loss, high robustness against PVT and do not require DACs to operate. The particular differential topology is less sensitive to parasitic effects of assembly provides an assembly (e.g. wire bonding) and suppresses second-order effects such as second order harmonics (H2, H4, ...) and intermodulation distortion (e.g. IP2) . Embodiments thus allow achieving a wideband discrete amplitude sweep with excellent performance such as low transmission phase variation. At the opposite of previous art, embodiments allow sweeping the amplitude of differential signals and are much less sensitive to parasitic effects of assembly (such as e.g. wire bonding).

In particular, embodiments of the present invention solve the mentioned assembly/packaging issues when the differential architecture is used. This is especially attractive for silicon based semiconductor technologies because the circuits are often differential (e.g. gilbert cell mixers).

Both described main beamformer architectures are suited for implementation in a transmit and/or receive module. The beamformers are based on the combination of a vector modulator and a distributed step attenuator for the purposes of phase and amplitude shifting, and an optional additional amplitude shifting, respectively. The vector modulator itself may make use of four distributed step attenuators as key components to accurately shift the amplitude and phase.

Brief description of the Figures

Some aspects of the invention will be described in the following by way of example only, and with reference to the accompanying figures, in which

Fig. 1      shows an apparatus for varying phase and amplitude of signals according to an embodiment of the present invention;

Fig. 2      depicts a possible architecture of a single-ended distributed step attenuator-based beamformer;

Fig. 3:     depicts an exemplary basic topology of a single-ended distributed attenuator;

Fig. 4:     depicts an exemplary circuitry of the basic topology of the single-ended distributed attenuator;

Fig. 5:     depicts a possible architecture of a differential distributed step attenuator based beamformer;

Fig. 6:     depicts an exemplary basic topology of a differential distributed attenuator according to an embodiment of the present invention;

Fig. 7:     depicts another exemplary basic topology of a differential distributed attenuator using coupled differential lines according to another embodiment;

Fig. 8:     depicts an exemplary circuitry of the basic topology of the differential distributed step attenuator presented in FIG. 6;

Fig. 9:     depicts an exemplary circuitry of the basic topology of the differential distributed step attenuator presented in FIG. 7; and

Fig. 10     depicts a flow diagram for a method for varying amplitude and phase of signals.

Detailed Description

The detailed description hereafter as well as the provided figures are only for the purpose of exemplary illustration and should not be seen as the only possible implementation of the invention. While the following description depicts two possible implementations that are sufficient for those skilled in the art to use the invention, it should be mentioned that other adaptations are possible without differentiating themselves from the core of the invention.

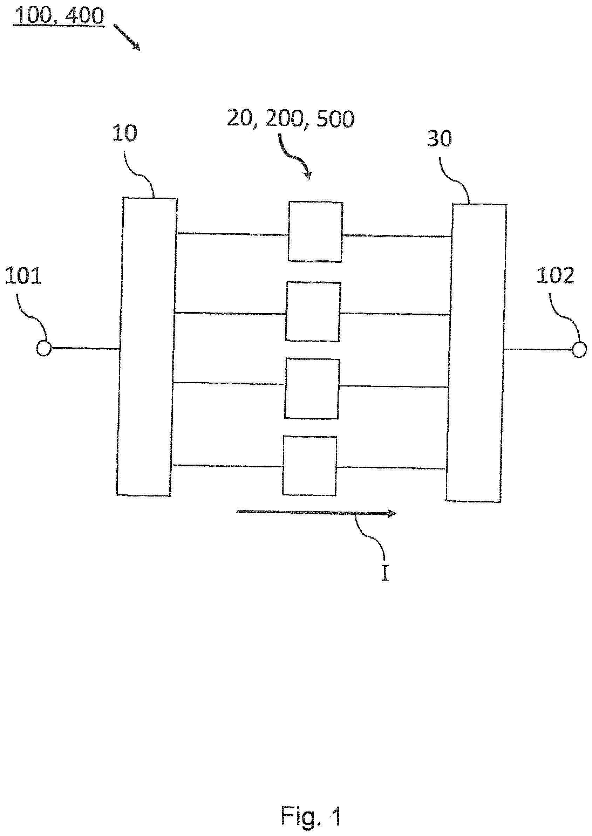

FIG. 1 shows an apparatus 400 that is suitable for varying amplitude and phase of signals along at least one signal path I. The apparatus comprises an input **101** for receiving an input signal, an output **102** for providing an output signal, a splitter **10**, a plurality of attenuators **500,** and an adder **30**. The splitter **10** is configured to split the input signal into a plurality of phase shifted signals. The plurality of attenuators 500 are controllable by corresponding control signals and are configured to attenuate individually each of the plurality of phase shifted signals. The adder **30** is configured to add the attenuated signals and to provide the added signals as the output signal.

It is understood that the input **101** and/or the output **102** shall not be limited to single-ended input/output lines, but may also include inputs/outputs for multiple lines (e.g. for differential signals). The signal path I connecting the input **101** and the output **102** may include multiple signal paths, e.g. parallel signal paths may be present. The step of adding may be carried out as a combining in that the phase and amplitude of the signals are added (i.e. as a vector adding).

In particular, the apparatus shown in FIG. 1 can be a vector modulator based on distributed attenuators and may be used for a beamformer.

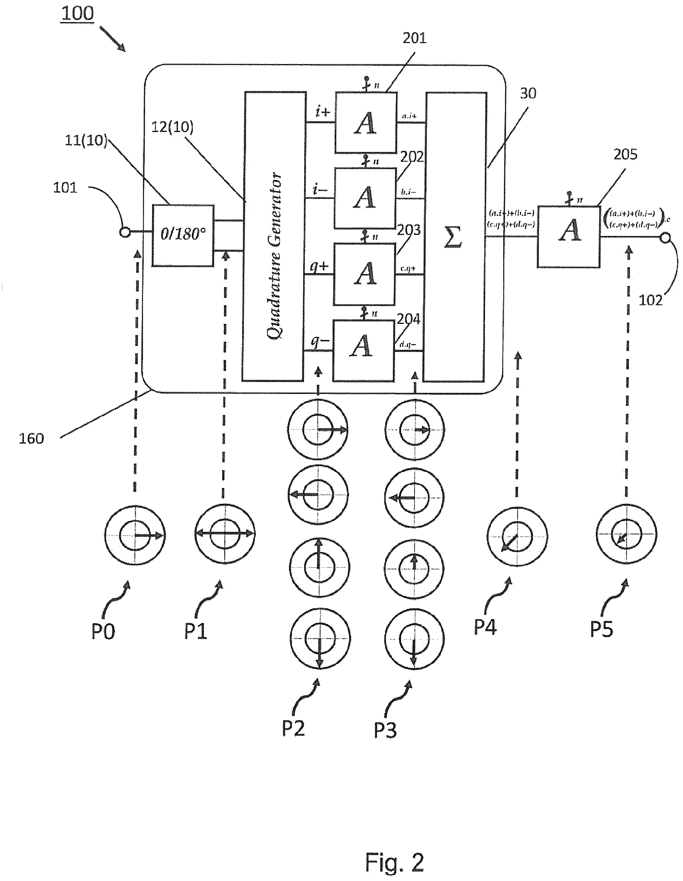

FIG. 2 depicts an architecture for such vector modulator **160** having an input **101** and being connected to an output **102** via an output attenuator **205**. The vector modulator **160** comprises the splitter **10** with a first splitter **11** and a second splitter **12**. The first splitter **11** is connected between the input **101** and the second splitter **12** and splits an input signal at the input **101** into two phase components which may have a relative phase shift of 180°. The second splitter **12** generates four vector signals i+, i-, q+, q- based on the output of the first splitter **11**. The vector signals i+, i-, q+, q- are each input into of four attenuators **201, 202, 203,** and **204** which attenuate the corresponding vector signal i+, i-, q+, q-. The vector modulator **160** also comprises the adder **30** which receives output signals from the four attenuators **201** to **204** and adds the signals which are fed into the output attenuator **205** and subsequently to the output **102**.

FIG. 2 further depicts below the phase and amplitude relations of a corresponding signals along the signal path I from the input **101** to the output **102**. For example, **P0** shows an exemplary phase and amplitude of the input signal of the first splitter **11**. The first splitter **11** generates two signals which have a relative phase shift of 180° as it is depicted in **P1**. These two phase shifted components are fed into the second splitter **12** which generates four vector signals i+, i-, q+, q- from the two input signals, which may be the corresponding phase components of the input signal and the relative phase relations are indicated in the diagrams **P2**. For example, if the first vector signal **i+** has the phase of 0°, the second vector signal **i-** has the phase of 180°, the third vector signal **q+** has the phase of 90° and the fourth vector signal **q-** has the phase of 270°. The four attenuators **201** to **204** attenuate each of the vector signals generated by the second splitter **12**. The result is shown in the phase diagrams **P3**. It is apparent that the phases of the attenuated signals are not changed, but the amplitudes are smaller. These four attenuated vector signals a.i+, b.i-, c.q+, d.q- (wherein a, b, c, d shall indicate the amount of attenuations) are fed into the adder **30** which adds the components and generates an output signal with the phase/amplitude depicted in **P4**. Finally, this added, attenuated signal (a.i+)+(b.i-)+(c.q+)+(d.q-) can be further attenuated by the output attenuator **205** resulting in the output signal:

$$((a.i+)+(b.i-)+(c.q+)+(d.q-)).e$$

where e again indicates the attenuation of output attenuator **205**. The phase/amplitude of the output signal is indicated in **P5**. Thus, the phase as well as the amplitude of the output signal have changed when compared to the input signal (see **P0**).

The architecture of FIG. 2 can, in particular, be used in a single-ended beamformer topology with the vector modulator **160** and the output attenuator **205** as an additional or external distributed step attenuator. As described, the vector modulator **160** is able to cover the entire phase range (usually 360°) and step (defined by the resolution) as well as part of the amplitude dynamic while the output attenuator **205** provides additional amplitude dynamic. In order to generate the four (in-quadrature) vectors **i+, i-, q+, q-,** the input of the vector modulator **160** comprises a 180° power splitter (usually defined as unbalanced-balanced or balun) as the first splitter **11** and a quadrature power splitter as the second splitter **12**.

In case a large RF bandwidth is targeted, a possible implementation of the balun **11** is e.g. an active balun or a broadband passive topology such as the Marchand balun. The quadrature power splitter **12** can be designed using e.g. a resistor-capacitor-based polyphase filter or an inductor-capacitor based all-pass filter. For example, each of the four generated phase shifted vectors may be 90° phase shifted and as said before is then fed into one of the four distributed step attenuator **201, 202, 203** and **204**. At the output of the distributed step attenuators **201, 202, 203** and **204** the four generated vectors with their own specific phase and amplitude are then combined in the vector adder **30.** The vector adder **30** can either be active or passive. The amplitude of the resulting vector can be additionally changed using the output attenuator **205.**

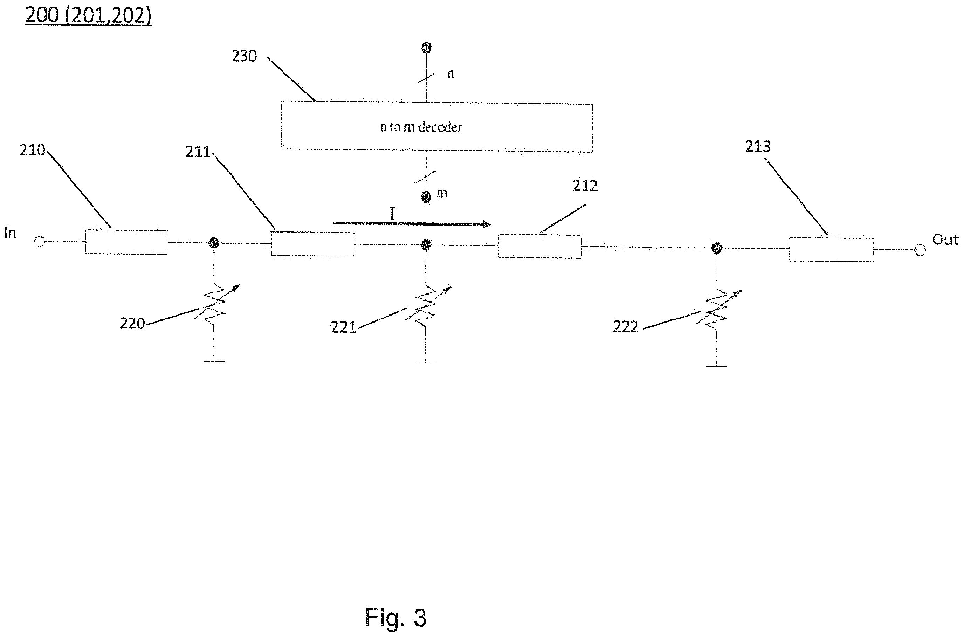

As further mentioned before, the proposed beamformer provides a drastic enhancement compared to prior art by using a distributed step attenuator topology. FIG. 3 presents a basic topology of a possible distributed step attenuator topology, i.e. an exemplary circuitry for each of the attenuators **201, 202,** .... The depicted attenuator **200** has a plurality of transmission lines **210, 211,** ... **213** which are connected along a signal path **I** between an input **In** and an output **Out.** Between pairs of adjacent transmission lines, a respective varistor **220, 221** ... **222** connects the signal path **I** to ground. For example, between the first transmission line **210** and the second transmission line **211** a first varistor **220** connects a node on the signal path **I** to ground. Between the second transmission line **211** and the third transmission line **212** a second varistor **221** connects likewise the signal path **I** to ground. This setup continues up the last transmission line **213** whose input is also connected via the last varistor **222** to ground.

The plurality of varistors **220,** ... may include $m$ varistors. Optionally a decoder **230** can be arranged between a control input of the attenuator **200** and may be configured to transform $n$ input signals into $m$ output signals which control the $m$ varistors **220,** .... The number $m$ may correspond to the number of possible achievable attenuations in the attenuator **200.** For example, the attenuation may be done stepwise, wherein the steps may not exceed a predetermined value (for example to avoid any reflection). By changing the amount of actuated varistors **220, 221** and **222,** the attenuation level can be controlled so that the $m$-stage attenuator **200** has $2^m$ possibilities of control. Since such a large amount of possibilities is often not required, the $n$ to $m$ bit decoder **230** can be used to convert the $2^m$ step attenuator to a $2^n$ step attenuator where $n<m$. As a result, a distributed step attenuator with $2^n$ amplitude settings is obtained.

In the presented distributed step attenuator **200,** the transmission lines **210, 211, 212** and **213** are used to match between the input and output impedance of the varistors **220, 221** and **222** which are placed between two of these lines.

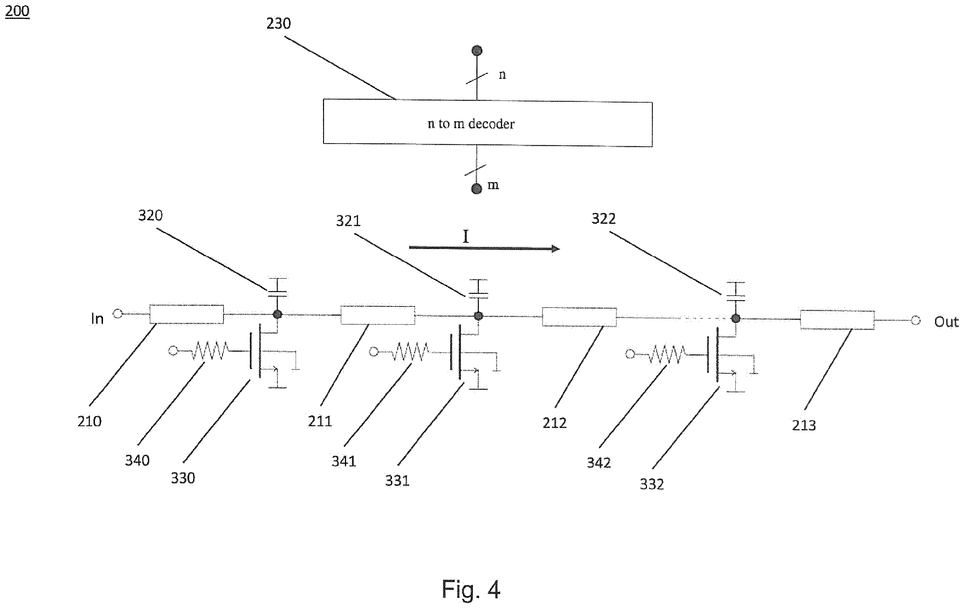

FIG. 4 illustrates one of the possible implementation of an $m$-stage distributed step attenuator **200** ($m$ being the amount of varistors) in a CMOS technology. However, it should be understood that the topology can be applied to any technology having field-effect transistors. In the architecture of FIG. 4 the plurality of varistors **220, 221, ...** each comprises a corresponding transistor **330, 331, 332** which connects a node between adjacent transmission lines **210, 211, ...** to ground. The transistors **330, 331, 333** comprise each a gate terminal which is connected to a corresponding control terminal via a corresponding resistor **340, 341, 342.** The control terminals are able to receive the $m$ control signals generated by the decoder **230.** In addition, nodes between each pair of adjacent transmission lines **210, 211** are connected via corresponding capacitors **320, 321,** ... directly to ground and represent shunt capacitors to reduce the physical dimensions of the transmission lines and to provide phase compensation as well.

In particular, the depicted distributed step attenuator **200** may comprise $m$ CMOS transistors (represented by **330, 331** and **332**) used as varistors, and the transmission lines (represented by **310, 311, 312** and **313**) placed at the input and output of each CMOS transistor **330, 331** and **332.** The connection of each transistor's gate to the resistor (represented by **340, 341, 342**) with a value of several k$\Omega$ provides a high impedance at this node.

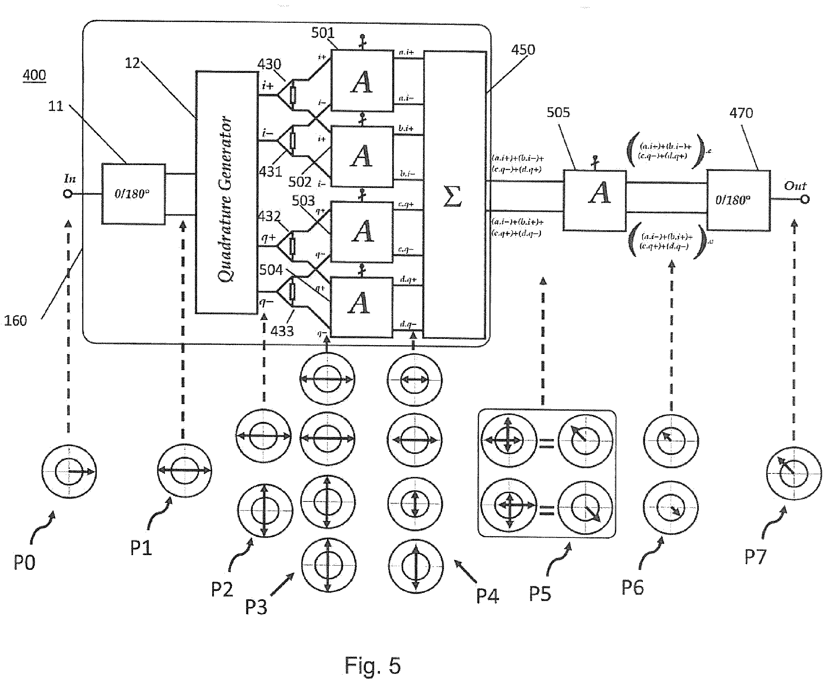

FIG. 5 depicts a possible architecture of a differential distributed step attenuator **400.** This architecture may also be used as a beamformer, but may also be used for any other application where amplitude and phase adaptations are desired.

It differs from the topology as shown in FIG. 2 in that each attenuator is replaced by differential step attenuators **501, 502, ..., 505.** Again, the vector modulator **160** comprises a first splitter **11** (as in FIG. 2) and a second splitter **12** that is implemented, for example, as quadrature generator to output four vector signals **i+, i-, q+, q-.** In contrast to the architecture of FIG. 2, each of the four vector signals **i+, i-, q+, q-** is now split by corresponding splitter (e.g. power splitter) **430, 431, 432,** ... so that in total eight signals are generated from the input signal at the input **In.** These eight signals are now paired into four pairs, wherein each pair of signals may comprise a relative phase shift of 180° (differential signals). For example, the first attenuator **501** receives the vector signal **i+** and the vector signal **i-,** and the second attenuator **502** receives the first vector signal **i+** and the second vector signal **i-.** The same applies to the third and fourth attenuators **503** and **504** which receive each the third vector signal **q+** and the fourth vector signal **q-** having a relative phase of 180°.

The four attenuators **501** to **504** apply now corresponding attenuations on the differential input signals and output attenuated differential signals a.i$\pm$, b.i$\pm$, c.q$\pm$ and d.q$\pm$ which are added by the adder **450** (a, b, c, d indicate again the attenuation levels). The adder **450** adds, for example, the component a.i+, b.i-, c.q- and d.q+ and, in the same way, the components: a.i-, b.i+, c.q+ and d.q- and outputs these two added components. The final attenuator **505** is again a differential attenuator which receives the two added components from the adder **450** and provides the two attenuated differential components (e indicates again the level of attenuation):

$$((a.i+)+(b.i-)+(c.q-)+(d.q+)).e \text{ and } ((a.i-)+(b.i+)+(c.q+)+(d.q-)).e$$

These attenuated, added components are fed into a phase combining unit **470** that undo the phase split by the first splitter **11** (or inverts one of the signal) and adds the two differential signals to provide the final output signal at the output **Out.**

The phase and amplitude relations of the various components are again depicted at the bottom side of FIG. 5, wherein each arrow relates to one phase component. **P0** refers to the input signal, **P1** to the two phase components generated by the first split component **11, P2** are the four vector signals **i+, i-, q+, q-,** which are combined into pairs of relative phase 180°. **P3** indicates the eight phase components of the differential signals fed into the four attenuators **501** to **504. P4** illustrates the phases of the output components of the four attenuators **501** to **504.** The added phase components are indicated in **P5** which are attenuated by the output attenuator **505** to generate the vectors **P6** as the two output signals. The phase split of these output signals is reversed in the phase combining unit **470** resulting in an output signal with a phase/amplitude as indicated in **P7.**

The differential architecture is especially attractive for wideband systems where harmonics and other non-linear effects can much more easily fall in the band of use. Additionally, differential circuits using silicon-based semiconductor technologies are less sensitive to assembly's parasitic effects.

The depicted topology can again be used in a beamformer, wherein the vector modulator **160** is again used to cover the entire required phase range (usually 360°) and step (defined by the resolution) as well as part of the amplitude dynamic while the external distributed step attenuator as output attenuator **505** provides additional amplitude dynamic. As described before, this topology is based on two pairs of differential signals, one pair being 90° phase shifted compared to the other pair, which can again be achieved by splitting the input into two differential signals using an balun as first splitter **11.** In case a large RF bandwidth is targeted, a possible implementation of the balun **11** comprises e.g. an active balun or a broadband passive topology such as the Marchand balun. The second splitter **12** can again be implemented by a quadrature power splitter. The quadrature power splitter **12** can be designed using e.g. a resistor-capacitor based polyphase filter or an inductor-capacitor based all-pass filter. Two in-quadrature differential signals are obtained at the output of the quadrature power splitter **12.** After a split by the corresponding splitters (e.g. power splitter) **430, 431, 432, ...** , the two pairs of differential signals, one pair being 90° phase shifted compared to the other pair go through the four distributed differential step attenuators **440, 441, 442** and **443** in order to shift their respective amplitude. The four resulting vectors are then summed within the signal adder **450.** The vector at the output of the adder **450** can have its amplitude further shifted within the differential distributed step attenuator as the output attenuator **505.** The differential vector is finally converted into a single-ended vector within a balun as phase combining unit **470.**

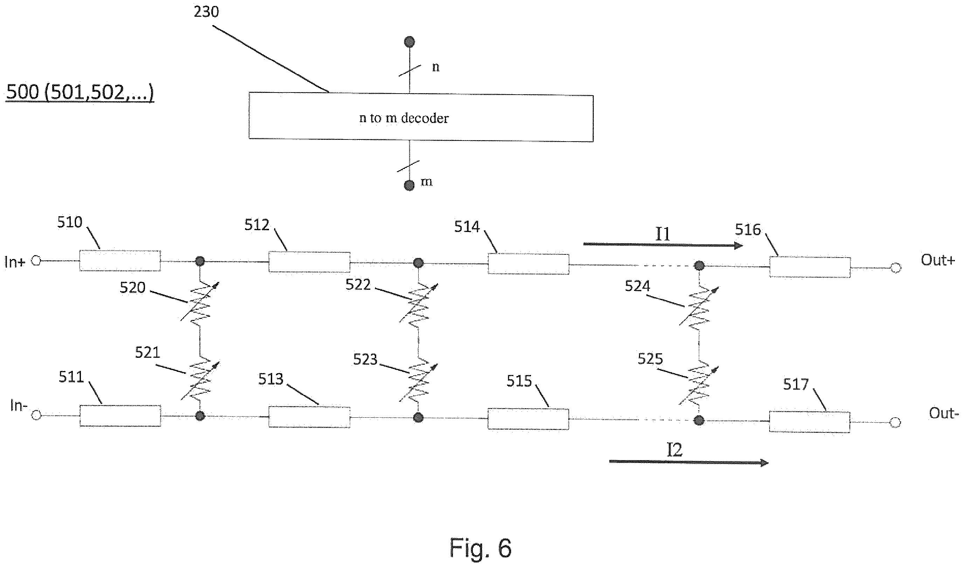

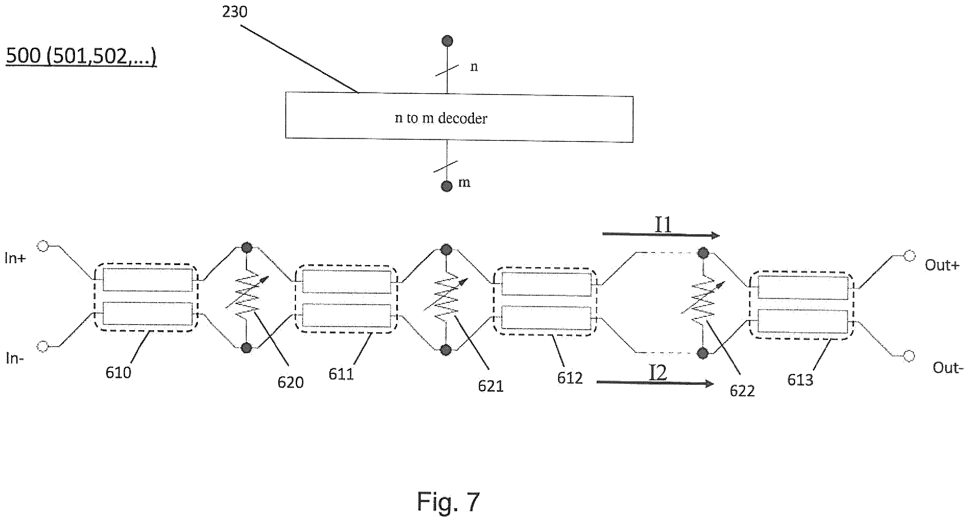

FIG. 6 and FIG. 7 show two simplified basic embodiments of differential distributed step attenuators **500** comprising two input terminals **In+, In-** and two output terminals **Out+, Out-** that can be used in the topology in FIG. 5. They may also be usable in other applications.

In FIG. 6 a first signal path **l1** connects a first input **In+** with a first output **Out+** and a second signal path **l2** connects a second input **In-** with a second output **Out-.** The input signals at **In+** and **In-** have a relative phase relation of 180°. As a result, the attenuation can be performed by connecting the first signal path **l1** with the second signal path **l2** by using varistors **520, 521, 522, ....** Again, transmission lines **510, 511, .... 517** are provided for an impedance matching along the first signal path **l1** and along the second signal path **l2.** In particular, the lines **510, 512, 514** and **516** are used to match between the input and output impedance of the varistors **520, 522** and **524** which are placed between two of these lines. The lines **511, 513, 515** and **517** are used to match between the input and output impedances of the varistors **521, 523** and **525** which are placed between two of these lines. In this differential distributed step attenuator **500,** the transmission lines **510** and **511** along different signal paths **l1, l2** are spatially separated so that they do not couple between each other. The same is valid for the line pairs **512/513, 514/515** as well as **516/517.** In this embodiment the varistors are provided in pairs **520/521, 522/523** and **524/525,** each pair connecting the first signal path **l1** with the second signal path **l2.** By changing the amount of actuated varistor pairs **520/521, 522/523** and **524/525,** the attenuation level can be controlled. In particular, the varistor pairs **520/521, 522/523** and **524/525,** may be controlled in the same way so that both varistors of one pair are turned on or turned off by a digital signal resulting in the desired attenuation of the propagating signals.

An $m$-stage attenuator ($m$ being the amount of varistor pairs) has again $2^m$ possibilities of control. Since such a large amount of possibilities is often not required, a $n$ to $m$ bit decoder **230** may be used to convert the $2^m$ step attenuator to a $2^n$ step attenuator where $n<m$. Therefore, a distributed step attenuator capable of varying the amplitude of differential signals with $2^n$ amplitude settings is obtained.

Although in the embodiment of FIG. 6 the transmission lines **510, 511, 512, 513, ...** decouple from each other, this is not a necessary condition. Rather, the transmission lines **510, 512, ...** along the first signal path **l1** may couple to the corresponding transmission lines **511, 513, ...** along the second signal path **l2.**

FIG. 7 depicts such an implementation, where the transmission lines are pair-wise coupled to each other. For example, a first pair **610** comprises the first transmission line **510** and the second transmission line **511** of Fig. 6, a second pair **611** couples the second transmission line **512** along the first signal path **l1** with the second transmission line **513** along the second signal path **l2.** Between adjacent pairs again corresponding varistors **620, 621, ...** are arranged to provide a desired attenuation of signals propagating along the first signal path **I1** and the second signal path **I2.** The line pairs **610, 611, 612** and **613** are again used to match between the input and output impedance of the varistors **620, 621** and **622** which are placed between two of these lines.

In this differential distributed step attenuator **500,** the line pairs **610, 611, 612** and **613** are, in particular, differential coupled lines. This has the advantage of improving common-mode suppression within the entire exemplary beamformer architecture. By changing the amount of actuated varistors **620, 621** and **622,** the attenuation level can be controlled. An $m$-stage attenuator has $2^m$ possibilities of control. Since such a large amount of possibilities is again often not required, a $n$ to $m$ bit decoder **230** can be used to convert the $2^m$ step attenuator to a $2^n$ step attenuator where $n<m$. Therefore, a distributed step attenuator **500** capable of varying the amplitude of differential signals with $2^n$ amplitude settings is obtained.

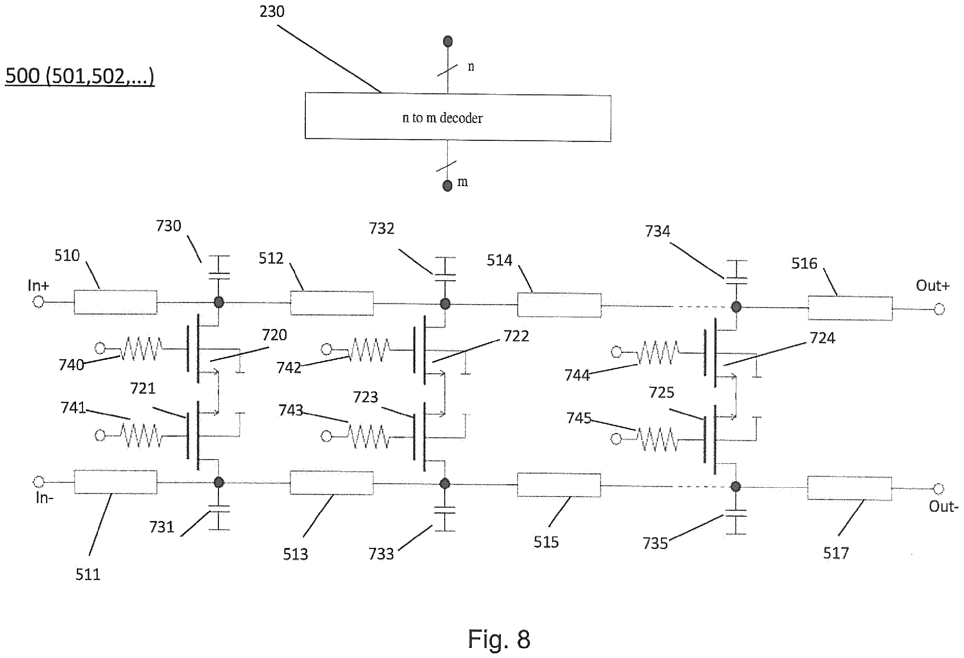

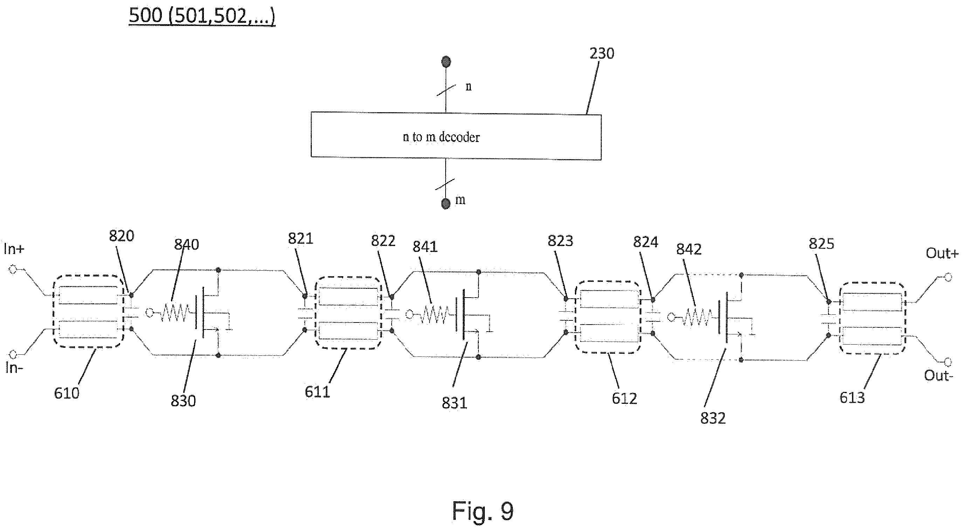

FIG. 8 and FIG. 9 depict possible realizations of the varistors shown in FIG. 6 and FIG. 7. Each of the varistors can again be realized by a transistor **720, 721,** ... (e.g. CMOS transistors), whose gate is connected via a resistor **740, 741** with a corresponding control terminal. The plurality of control terminals can again be connected to the decoder **230** and be controlled by an n input signal line which is decoded into m output signal lines which control the plurality of transistors.

FIG. 8 depicts an exemplary embodiment of the basic distributed step attenuator **500** topology presented in FIG. 6. The topology comprises the transmission lines **510, 511, 512, 513, 514, 515, 516** and **517** which are used to match the input and output impedance of the CMOS transistors **720, 721, 722, 723, 724** and **725.** The CMOS transistors **720, 721, 722, 723, 724** and **725** are used as varistors within this circuit, however other types of field effect transistors could also be used. The gate of each CMOS transistor **720, 721, 722, 723, 724** and **725** is terminated with the corresponding resistor **740, 741, 742, 743, 744** and **745** with a value of several k$\Omega$ to provide a high impedance termination.

In order to reduce the physical dimensions of the transmission lines and to provide phase compensation as well, shunt capacitors (represented by **730, 731, 732, 733, 734** and **735**) can be added to the standard topology. The capacitors **730, 731, 732, 733, 734** and **735** are connected to the transistors **720, 721, 722, 723, 724** and **725,** respectively. An $m$-stage attenuator has $2^m$ possibilities of control. Since such a large amount of possibilities is again often not required, a $n$ to $m$ bit decoder **230** can be used to convert the $2^m$ step attenuator to a $2^n$ step attenuator where $n<m$. Therefore, a distributed step attenuator capable of varying the amplitude of differential signals with $2^n$ amplitude settings is obtained.

FIG. 9 depicts an exemplary embodiment of the basic distributed step attenuator topology presented in FIG. 7. The topology comprises the differential coupled transmission line pairs **610, 611, 612** and **613** which are used to match the input and output impedance of CMOS transistors **830, 831** and **832** that are used as varistors in the embodiment. However, the invention is not limited to CMOS transistors, but other types of field effect transistors can also be used. The gate of each CMOS transistor **830, 831** and **832** is terminated with a resistor **840, 841** and **842** with a value of several k$\Omega$ to provide a high impedance termination. In order to reduce the physical dimensions of the transmission lines and to provide phase compensation as well, shunt capacitors (represented by **820, 821, 822, 823, 824** and **825**) may again be added to the standard topology. The capacitor pairs **820/821, 822/823** and **824/ 825** are connected to the drain and source of the CMOS transistors **830, 831** and **832,** respectively. An $m$-stage attenuator has $2^m$ possibilities of control. Since such a large amount of possibilities is not required, a $n$ to $m$ bit decoder **230** can again be used to convert the $2^m$ step attenuator to a $2^n$ step attenuator where $n<m$. Therefore, a distributed step attenuator capable of varying the amplitude of differential signals with $2^n$ amplitude settings is obtained.

It is understood that the apparatus 100 of FIG.2 and the apparatus 400 of Fig. 5 may in principle also be combined in that some of the attenuators may be single-ended and others not.

Embodiments of the present invention relate also to the distributed step attenuators as described herein (e.g. in FIGs 6-9), which are very attractive circuit architectures, because of its low loss, low parasitic transmission phase, high linearity and robustness against process, voltage and temperature variation. Additionally, no DACs are required to control the attenuator as need in conventional vector modulators.

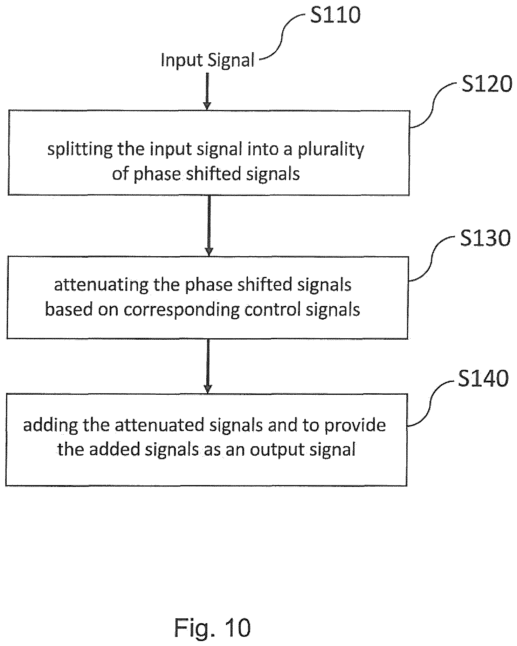

FIG. 10 shows a flow diagram for a method for varying amplitude and phase of signals along a signal path I. The method comprises the steps: receiving S110 an input signal, splitting S120 the input signal into a plurality of phase shifted signals, attenuating S130 the phase shifted signals based on corresponding control signals, and adding S140 the attenuated signals and to provide the added signals as an output signal.

It is understood that each functional feature described in conjunction with the apparatus may also be implemented as further method steps. In addition, the method disclosed in the specification or in the claims may be implemented by a device having means for performing each of the respective acts of these methods.

Further, it is to be understood that the disclosure of multiple acts or functions disclosed in the specification or claims may not be construed as to be within the specific order. Therefore, the disclosure of multiple acts or functions will not limit these to a particular order unless such acts or functions are not interchangeable for technical reasons. Furthermore, in some examples a single act may include or may be broken into multiple sub acts. Such sub acts may be included and part of the disclosure of this single act unless explicitly excluded.

Furthermore, while each embodiment may stand on its own as a separate example, it is to be noted that in other embodiments the defined features can be combined differently, i.e. a particular feature described in one embodiment may also be realized in other embodiments. Such combinations are covered by the disclosure herein unless it is stated that a specific combination is not intended.

List of reference signs

| | |
|---|---|
| 10 | splitter |
| 20, 200; 500 | attenuators |
| 30 | adder |
| 100, 400 | apparatus for varying amplitudes |
| 101 | input |
| 102 | output |
| 210,211,510,511,.. | transmission lines |
| 220,520, 620, | varistors |
| 230; 530 | decoder |
| 205, 505 | output attenuators |
| 320, 730 820 | capacitors |
| 330, 720, 830,... | transistors |
| 610, 611, ... | pairs of transmission lines |
| I, I1, I2 | signal paths |
| i+, i-, q+, q- | vector signals |
| In+, In- | differential input lines |
| Out+, Out- | differential output lines |

**Claims**

1. An attenuator (500) comprising:

   a two-line input (In+, In-) and a two-line output (Out+, Out-) connected by a first signal path (I1) and a second signal path (I2) for enabling the attenuator (500, 501, ...) to attenuate differential signals;
   a first plurality of transmission lines (510, 512, ...) being arranged along the first signal path (I1) and a second plurality of transmission lines (511, 513, ...) being arranged along the second signal path (I2); and
   one or more varistors (520, 521) arranged between adjacent transmission lines (510, 512, 511, 513) along the first signal path (I1) and the second signal path (I2), each varistor connecting the first signal path (I1) and the second signal path (I2) to controllably connect the first signal path (I1) with the second signal path (I2), thereby attenuating the differential signals.

2. An apparatus (400) for varying amplitude and phase of signals along at least one signal path (I), the apparatus comprising:

   an input (101) for receiving an input signal;
   an output (102) for providing an output signal;
   a splitter (10) configured to split the input signal into a plurality of phase shifted signals;
   a plurality of attenuators (500) according to claim 1 controllable by corresponding control signals and configured to attenuate the plurality of phase shifted signals; and
   an adder (30) configured to add the attenuated signals and to provide the added signals as the output signal.

3. The apparatus (400) according to claim 2, wherein each varistor (220; 520) is configured to lower an amplitude of a signal propagating along the signal path (I) depending on one of the control signals, the transmission lines (210, 211, ... ; 510, 511, ...) being configured to provide an impedance matching along the signal path (I).

4. The apparatus (400) according to claim 3, wherein at least some of the attenuators (500) comprise each at least m varistors (220, 221, ...; 520, 521, ...) and a decoder (230; 530), the corresponding control signal being input in the decoder (230; 530) and indicating n input states, the decoder (230) being configured to transform the n input states into m output control signals and to provide the output control signals to the m varistors (220, 221, ... ; 520, 521, ...)

respectively, wherein m is larger than n.

5. The apparatus (400) according to one of the claims 2 to 4, wherein the splitter (10) is configured to generate as phase shifted signals from the input signal four vector signals (i+, i-, q+, q-) and to provide each of the vector signals (i+, i-, q+, q-) to one respective attenuator of the plurality of attenuators (500).

6. The apparatus (400) according to one of the claims 2 to 5, wherein the plurality of attenuators (500) includes an output attenuator (205; 505) arranged between the adder (30) and the output (102) to attenuate the added signal and provide the attenuated added signal as output signal.

7. The apparatus (400) according to one of the claims 3 to 6,
the splitter (10) being further configured to provide, based on the phase-shifted signals, pairs of differential signals, wherein at least some of the attenuators (500, 501, ...) comprise each a two-line input (In+, In-) and a two-line output (Out+, Out-) connected by a first signal path (I1) and a second signal path (I2) for enabling the attenuators (500, 501, ...) to attenuate differential signals,
wherein one or more varistors (520, 521) are arranged between adjacent transmission lines (510, 512; 511, 513) along the first signal path (I1) and the second signal path (I2) to controllably connect the first signal path (I1) with the second signal path (I2), thereby attenuating the differential signals.

8. The apparatus (400) according to claim 7, wherein the first plurality of transmission lines (510, 512, ...) is arranged to decouple from the second plurality of transmission lines (511, 513, ...).

9. The apparatus (400) according to claim 7 or claim 8, wherein each varistor (520, 521, ...) comprises at least one transistor (720, 721, ...; 830, 831, ...) controlled by the control signals to simultaneously attenuate amplitudes of signals propagating along the first signal path (I1) and signals propagating along the second signal path (I2).

10. A beamforming architecture comprising an antenna array and one or more transmit and/or receive modules with at least two apparatuses according to one of the claims 2 to 9.

11. The beamforming architecture according to claim 10, further comprising a control unit configured to control the plurality of attenuators (20, 200; 500) in the at least two apparatuses to direct a transmission beam in a defined transmission direction or to increase a sensitivity for a received beam from defined receiving direction.

12. A method comprising:

receiving (S110) a differential input signal on a two-line input (In+, In-), the two-line input (In+, In-) being connected with a two-line output (Out+, Out-) by a first signal path (I1) and a second signal path (I2), wherein a first plurality of transmission lines (510, 512, ...) is arranged along the first signal path (I1) and a second plurality of transmission lines (511, 513, ...) is arranged along the second signal path (I2); and
attenuating (S130) the differential input signal by one or more varistors (520, 521) arranged between adjacent transmission lines (510, 512, 511, 513) along the first signal path (I1) and the second signal path (I2), wherein each varistor controllably connects the first signal path (I1) with the second signal path (I2).


**Patentansprüche**

1. Ein Dämpfungsglied (500), umfassend:

einen Doppelleitungseingang (In+, In-) und einen Doppelleitungsausgang (Out+, Out-), die durch einen ersten Signalweg (I1) und einen zweiten Signalweg (I2) verbunden sind, um dem Dämpfungsglied (500, 501, ...) zu ermöglichen, differenzielle Signale zu dämpfen;
eine erste Vielzahl von Übertragungsleitungen (510, 512, ...), die entlang des ersten Signalwegs (I1) angeordnet sind, und eine zweite Vielzahl von Übertragungsleitungen (511, 513, ...), die entlang des zweiten Signalwegs (I2) angeordnet sind; und
ein oder mehr Varistoren (520, 521), die zwischen benachbarten Übertragungsleitungen (510, 512, 511, 513) entlang des ersten Signalwegs (I1) und des zweiten Signalwegs (I2) angeordnet sind, wobei jeder Varistor den ersten Signalweg (I1) und den zweiten Signalweg (I2) verbindet, um den ersten Signalweg (I1) steuerbar mit dem zweiten Signalweg (I2) zu verbinden und dadurch die differenziellen Signale zu dämpfen.

2. Eine Vorrichtung (400) zum Verändern von Amplitude und Phase von Signalen entlang wenigstens eines Signalwegs (I), die Vorrichtung umfasst:

> einen Eingang (101) zum Empfangen eines Eingangssignals;
> einen Ausgang (102) zum Bereitstellen eines Ausgangssignals;
> einen Verteiler (10), der ausgebildet ist, um das Eingangssignal in eine Vielzahl von phasenverschobenen Signalen zu verteilen;
> eine Vielzahl von Dämpfungsgliedern (500) nach Anspruch 1, die durch entsprechende Steuersignale steuerbar sind und die ausgebildet sind, um die Vielzahl von phasenverschobenen Signalen zu dämpfen; und
> ein Addierer (30), der ausgebildet ist, um die gedämpften Signale zu addieren und die addierten Signale als das Ausgangssignal bereitzustellen.

3. Die Vorrichtung (400) nach Anspruch 2, wobei jeder Varistor (220; 520) ausgebildet ist, um eine Amplitude eines Signals, das sich abhängig von einem der Steuersignale entlang des Signalwegs (I) ausbreitet, zu senken, und wobei die Übertragungsleitungen (210, 211, ...; 510, 511, ...) ausgebildet sind, um eine Impedanzanpassung entlang des Signalwegs (I) bereitzustellen.

4. Die Vorrichtung (400) nach Anspruch 3, wobei wenigstens manche der Dämpfungsglieder (500) jeweils wenigstens m Varistoren (220, 221, ...; 520, 521, ...) und einen Decoder (230; 530) umfassen, wobei das entsprechende Steuersignal in den Decoder (230; 530) eingeht und n Eingangszustände anzeigt, wobei der Decoder (230) ausgebildet ist, um die n Eingangszustände in m Ausgangssteuersignale umzuwandeln und die Ausgangssteuersignale den m Varistoren (220, 221, ...; 520, 521, ...) jeweils entsprechend bereitzustellen, wobei m größer ist als n.

5. Die Vorrichtung (400) nach einem der Ansprüche 2 bis 4, wobei der Verteiler (10) ausgebildet ist, um aus dem Eingangssignal vier Vektorsignale (i+, i-, q+, q-) als phasenverschobene Signale zu erzeugen, und um jedes der Vektorsignale (i+, i-, q+, q-) einem entsprechenden Dämpfungsglied aus der Vielzahl von Dämpfungsgliedern (500) bereitzustellen.

6. Die Vorrichtung (400) nach einem der Ansprüche 2 bis 5, wobei die Vielzahl von Dämpfungsgliedern (500) ein Ausgangsdämpfungsglied (205; 505) umfasst, das zwischen dem Addierer (30) und dem Ausgang (102) angeordnet ist, um das addierte Signal zu dämpfen und das gedämpfte addierte Signal als Ausgangssignal bereitzustellen.

7. Die Vorrichtung (400) nach einem der Ansprüche 3 bis 6, wobei
der Verteiler (10) weiter ausgebildet ist, um, basierend auf den phasenverschobenen Signalen, Paare von differenziellen Signalen bereitzustellen,
wobei wenigstens manche der Dämpfungsglieder (500, 501, ...) jeweils einen Doppelleitungseingang (In+, In-) und einen Doppelleitungsausgang (Out+, Out-) umfassen, die durch einen ersten Signalweg (I1) und einen zweiten Signalweg (I2) verbunden sind, um den Dämpfungsgliedern (500, 501, ...) zu ermöglichen, die differenziellen Signale zu dämpfen,
wobei einer oder mehrere Varistoren (520, 521) zwischen angrenzenden Übertragungsleitungen (510, 512, 511, 513) entlang des ersten Signalwegs (I1) und entlang des zweiten Signalwegs (I2) angeordnet sind, um den ersten Signalweg (I1) steuerbar mit dem zweiten Signalweg (I2) zu verbinden und dadurch die differenziellen Signale zu dämpfen.

8. Die Vorrichtung (400) nach Anspruch 7, wobei die erste Vielzahl von Übertragungsleitungen (510, 512, ...) angeordnet ist, um von der zweiten Vielzahl von Übertragungsleitungen (511, 513, ...) zu entkoppeln.

9. Die Vorrichtung (400) nach Anspruch 7 oder Anspruch 8, wobei jeder Varistor (520, 521, ...) mindestens einen Transistor (720, 721, ...; 830, 831, ...) umfasst, der durch die Steuersignale gesteuert wird, um gleichzeitig Amplituden von Signalen, die sich entlang des ersten Signalwegs (I1) ausbreiten, und von Signalen, die sich entlang des zweiten Signalwegs (I2) ausbreiten, zu dämpfen.

10. Eine Strahlformungsarchitektur, die eine Antennenanordnung und ein oder mehrere Übertragungs- und/oder Empfangsmodule mit wenigstens zwei Vorrichtungen nach einem der Ansprüche 2 bis 9 umfasst.

11. Die Strahlformungsarchitektur nach Anspruch 10, die ferner eine Steuereinheit umfasst, die konfiguriert ist, um die Vielzahl von Dämpfungsgliedern (20, 200; 500) in den wenigstens zwei Vorrichtungen zu steuern, um einen Übertragungsstrahl in eine definierte Übertragungsrichtung zu leiten oder um eine Empfindlichkeit für einen empfangenen Strahl aus definierter Empfangsrichtung zu erhöhen.

**12.** Ein Verfahren, umfassend:

Empfangen (S110) eines differenziellen Eingangssignals über einen Doppelleitungseingang (In+, In-), wobei der Doppelleitungseingang (In+, In-) mit einem Doppelleitungsausgang (Out+, Out-) durch einen ersten Signalweg (I1) und einen zweiten Signalweg (I2) verbunden ist, wobei eine erste Vielzahl von Übertragungsleitungen (510, 512, ...) entlang des ersten Signalwegs (I1) angeordnet ist, und eine zweite Vielzahl von Übertragungsleitungen (511, 513, ...) entlang des zweiten Signalwegs (I2) angeordnet ist; und
Dämpfen (S130) des differenziellen Eingangssignals durch einen oder mehrere Varistoren (520, 521), die zwischen angrenzenden Übertragungsleitungen (510, 512, 511, 513) entlang des ersten Signalwegs (I1) und des zweiten Signalwegs (I2) angeordnet sind, wobei jeder Varistor den ersten Signalweg (I1) steuerbar mit dem zweiten Signalweg (I2) verbindet.

**Revendications**

**1.** Atténuateur (500) comprenant :

une entrée à deux lignes (In+, In-) et une sortie à deux lignes (Out+, Out-) connectées par un premier trajet de signal (I1) et un second trajet de signal (I2) pour permettre à l'atténuateur (500, 501, ...) d'atténuer des signaux différentiels ;
une première pluralité de lignes de transmission (510, 512, ...) étant agencées le long du premier trajet de signal (I1) et une seconde pluralité de lignes de transmission (511, 513, ...) étant agencées le long du second trajet de signal (I2) ; et
une ou plusieurs varistances (520, 521) agencées entre des lignes de transmission adjacentes (510, 512, 511, 513) le long du premier trajet de signal (I1) et du second trajet de signal (I2) chaque varistance connectant le premier trajet de signal (I1) au second trajet de signal (I2) pour commander la connexion du premier trajet de signal (I1) au second trajet de signal (I2), atténuant ainsi les signaux différentiels.

**2.** Appareil (400) pour faire varier l'amplitude et la phase de signaux le long d'au moins un trajet de signal (I) l'appareil comprenant :

une entrée (101) pour recevoir un signal d'entrée ;
une sortie (102) pour fournir un signal de sortie ;
un diviseur (10) configuré pour diviser le signal d'entrée en une pluralité de signaux déphasés ;
une pluralité d'atténuateurs (500) selon la revendication 1 pouvant être commandés par des signaux de commande correspondants et configurés pour atténuer la pluralité de signaux déphasés ; et
un sommateur (30) configuré pour additionner les signaux atténués et pour fournir les signaux additionnés en tant que signal de sortie.

**3.** Appareil (400) selon la revendication 2, dans lequel chaque varistance (220 ; 520) est configurée pour abaisser une amplitude d'un signal se propageant le long du trajet de signal (I) en fonction de l'un des signaux de commande, les lignes de transmission (210, 211, ... ; 510, 511, ...) étant configurées pour fournir une adaptation d'impédance le long du trajet de signal (I).

**4.** Appareil (400) selon la revendication 3, dans lequel au moins certains des atténuateurs (500) comprennent chacun au moins m varistances (220, 221, ... ; 520, 521, ...) et un décodeur (230 ; 530), le signal de commande correspondant étant entré dans le décodeur (230 ; 530) et indiquant n états d'entrée, le décodeur (230) étant configuré pour transformer les n états d'entrée en m signaux de commande de sortie et fournir les signaux de commande de sortie aux m varistances (220, 221, ... ; 520, 521, ...) respectivement, m étant supérieur à n.

**5.** Appareil (400) selon l'une des revendications 2 à 4, dans lequel le diviseur (10) est configuré pour générer en tant que signaux déphasés de quatre signaux vectoriels du signal d'entrée (i+, i-, q+, q-) et pour fournir chacun des signaux vectoriels (i+, i-, q+, q-) à un atténuateur respectif de la pluralité d'atténuateurs (500).

**6.** Appareil (400) selon l'une des revendications 2 à 5, dans lequel la pluralité d'atténuateurs (500) comporte un atténuateur de sortie (205 ; 505) agencé entre le sommateur (30) et la sortie (102) pour atténuer le signal additionné et fournir le signal additionné atténué en tant que signal de sortie.

7. Appareil (400) selon l'une des revendications 3 à 6,
le diviseur (10) étant en outre configuré pour fournir, sur la base des signaux déphasés, des paires de signaux différentiels,
dans lequel au moins certains des atténuateurs (500, 501, ...) comprennent chacun une entrée à deux lignes (In+, In-) et une sortie à deux lignes (Out+, Out-) connectées par un premier trajet de signal (I1) et un second trajet de signal (I2) pour permettre aux atténuateurs (500, 501, ...) d'atténuer des signaux différentiels,
dans lequel une ou plusieurs varistances (520, 521) sont agencées entre des lignes de transmission adjacentes (510, 512 ; 511, 513) le long du premier trajet de signal (I1) et du second trajet de signal (I2) pour commander la connexion du premier trajet de signal (I1) au second trajet de signal (I2), atténuant ainsi les signaux différentiels.

8. Appareil (400) selon la revendication 7, dans lequel la première pluralité de lignes de transmission (510, 512, ...) est agencée pour se découpler de la seconde pluralité de lignes de transmission (511, 513, ...).

9. Appareil (400) selon la revendication 7 ou la revendication 8, dans lequel chaque varistance (520, 521, ...) comprend au moins un transistor (720, 721, ... ; 830, 831, ...) commandé par les signaux de commande pour atténuer simultanément les amplitudes de signaux se propageant le long du premier trajet de signal (I1) et de signaux se propageant le long du second trajet de signal (I2).

10. Architecture de formation de faisceau comprenant un réseau d'antennes et un ou plusieurs modules de transmission et/ou de réception avec au moins deux appareils selon l'une des revendications 2 à 9.

11. Architecture de formation de faisceau selon la revendication 10, comprenant en outre une unité de commande configurée pour commander la pluralité d'atténuateurs (20, 200 ; 500) dans lesdits au moins deux appareils pour diriger un faisceau de transmission dans une direction de transmission définie ou pour augmenter une sensibilité pour un faisceau reçu d'une direction de réception définie.

12. Procédé comprenant :

la réception (S110) d'un signal d'entrée différentiel sur une entrée à deux lignes (In+, In-), l'entrée à deux lignes (In+, In-) étant connectée à une sortie à deux lignes (Out+, Out-) par un premier trajet de signal (I1) et un second trajet de signal (I2), dans lequel une première pluralité de lignes de transmission (510, 512, ...) est disposée le long du premier trajet de signal (I1) et une seconde pluralité de lignes de transmission (511, 513 , ...) est disposée le long du second trajet de signal (I2) ; et
l'atténuation (S130) du signal d'entrée différentiel par une ou plusieurs varistances (520, 521) agencées entre des lignes de transmission adjacentes (510, 512, 511, 513) le long du premier trajet de signal (I1) et du second trajet de signal (I2), dans lequel chaque varistance commande la connexion du premier trajet de signal (I1) au second trajet de signal (I2).

100, 400

10

20, 200, 500

30

101

102

I

Fig. 1

Fig. 2

200 (201,202)

Fig. 3

EP 3 447 915 B1

Fig. 4

Fig. 5

Fig. 6

500 (501,502,...)

n to m decoder

n

m

230

In+

In-

Out+

Out-

610

620

611

621

612

622

613

I1

I2

Fig. 7

Fig. 8

500 (501,502,...)

Fig. 9

EP 3 447 915 B1

S110

Input Signal

S120

splitting the input signal into a plurality
of phase shifted signals

S130

attenuating the phase shifted signals
based on corresponding control signals

S140

adding the attenuated signals and to provide
the added signals as an output signal

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020110015961

### Non-patent literature cited in the description

- **KWANG-JIN KOH ; GABRIEL M. REBEIZ.** An X- and Ku-Band 8-Element Phased-Array Receiver in 0.18-$\mu$m SiGe BiCMOS Technology. *IEEE Journal of Solid-Sate Circuits,* June 2008, vol. 43 (6
- **UWE MAYER ; MICHAEL WICKERT ; RALF EICKHOFF ; FRANK ELLINGER.** 2-6-GHz BiCMOS Polar- Based Vector Modulator for S- and C-Band Diversity Receivers. *IEEE Transactions on Microwave Theory and Techniques,* June 2008, vol. 60 (3
- **BYUNG-WOOK MIN ; GABRIEL M. REBEIZ.** A 10-50-GHz CMOS Distributed Step Attenuator With Low Loss and Low Phase Imbalance. *IEEE Journal of Solid-Sate Circuits,* November 2007, vol. 42 (11
- **KYUNGWON KIM ; HYO-SUNG LEE ; BYUNG-WOOK MIN.** V-W Band CMOS Distributed Step Attenuator With low Phase Imbalance. *IEEE Microwave And Wireless Components Letters,* August 2014, vol. 24 (8